# EUROPEAN PATENT APPLICATION

(11) **EP 0 959 493 A2**
(43) Date of publication of application: **24.11.1999**
(21) Application number: 98118024.3
(22) Date of filing: 23.09.1998
(51) Int. Cl.: H01L 21/316, H01L 21/762, H01L 21/768

(54) **Deposition of insulating films by CVD**

(30) Priority: 20.05.1998 JP 13804098
(71) Applicant: Semiconductor Process Laboratory Co., Ltd., Minato-ku, Tokyo 108-0075 (JP)
(72) Inventor: Maeda, Kazuo, Kanagawa 248-0075 (JP); Nishimoto, Yuhko, Tokyo 154-0012 (JP)
(74) Representative: Schwabe - Sandmair - Marx

(57) **Abstract**

This invention relates to a method of film formation in which, when a silicon oxide film (a NSG film : a Non-doped Silicate Glass) is formed on a substrate having a recess by a CVD method using a mixed gas containing a TEOS and ozone, a surface dependency of the substrate is deleted to embed a silicon oxide film into the recess of the surface thereof. The invention comprises a process forming a phosphorus containing insulating film 14 as a base layer on the surface of a substrate 11 and a process forming a silicon-containing insulating film 15 on the phosphosilicate glass film 14 by the chemical vapor deposition method used a mixed gas containing a ozone-containing gas and a silicon-containing gas.

## Description

### BACK GROUND OF THE INVENTION

### 1.Field of the Invention

This invention relates to a method of film formation and a method for manufacturing a semiconductor device in which, when a silicon oxide film (a NSG film: a Non-doped Silicate Glass) is formed on a substrate having a recess by a CVD method using a mixed gas containing a TEOS and ozone, a surface dependency of the substrate is deleted to embed a silicon oxide film into the recess of the surface thereof.

The surface dependency is defined as a property such that a film formation depends on a property of a surface on which a film is deposited.

### 2.Description of the Prior Art

In recent years, micronizing has been advanced in the semiconductor device. The recess narrow in width and deeper in depth such as the recess between wirings and the recess in which an insulating material is embedded for an insulating element separation is designed to be formed on a semiconductor substrate surface. In such semiconductor device, an insulating film is required to be embedded in the recess.

Therefore, the silicon oxide film excellent in film quality (hereinafter referred to as a High O₃/TEOS SiO₂ film) is required to be formed and to be embedded in the recess without clearance. A CVD method is used as a method of the film formation. Mixed gas containing both the TEOS (Tetraethylorthosilicate) and the ozone-containing gas containing high concentration O₃ is used as a deposition gas, said ozone-containing gas containing O₃ of 1 % or more in O₂.

However, since the High O₃/TEOS SiO₂ film is sensitive to a property of the surface of the substrate, a property of a depositing film tends to be influenced. An influence of the surface dependency appears as reduction of a film formation rate, surface roughness of the depositing film and reduction of film quality. Therefore, in order to deposit the High O₃/TEOS SiO₂ film having the same film formation rate, surface condition of the depositing film and the film quality of the depositing film where the film on a silicon substrate is deposited, it is required for the surface of the substrate to design the film formation of the High O₃/TEOS SiO₂ film to be not influenced by the surface dependency. Heretofore, in order to delete such surface dependency, the following countermeasures are given:
①The silicon oxide film is formed as a base layer on the surface of the substrate by a plasma enhanced CVD. This is disclosed in Japanese Laid-open Patent Publication No.Hei.7-211712.
②The surface of the substrate is exposed to plasma gases. This is disclosed in Japanese Laid-open Patent Publication No.Hei.4-94539.
③The silicon oxide film (hereinafter referred to as a Low O₃/TEOS SiO₂ film) is formed as a base layer on the surface of the substrate by the CVD method. As the film formation gas, the reaction gas containing the ozone-containing gas containing low concentration O₃ whose the concentration of O₃ in O₂ is less than 1 % and the TEOS is used. This is disclosed in Japanese Laid-open Patent Publication No.Hei.3-198340. Furthermore, the following method that the methods described above are combined is used.
④The Low O₃/TEOS SiO₂ film is formed as the base layer on the surface of the substrate by the CVD method and subsequently, the Low O₃/TEOS SiO₂ film is exposed to plasma gases. A reaction gas containing both the TEOS and a low ozone-containing gas such that the concentration of O₃ in O₂ is as low as less than 1 % is used as the film formation gas of the Low O₃/TEOS SiO₂ film.
⑤The High O₃/TEOS SiO₂ film is formed as the base layer on the surface of the substrate by the CVD method and subsequently, the High O₃/TEOS SiO₂ film is exposed to plasma gases. A reaction gas containing both the TEOS and a high ozone-containing gas such that the concentration of O₃ in O₂ is as high as not less than 1 % is used as the film formation gas of the High O₃/TEOS SiO₂ film.

In addition, the methods for delating the surface dependency of the substrate are disclosed in Japanese Laid-open Patent Publication No.Hei.7-66131 or the like.

By such method, the O₃/TEOS SiO₂ film of which the depositing film does not depend upon the surface dependency of the substrate and which has the sufficient fluid ability can be formed.

### PROBLEMS TO BE SOLVED BY THE INVENTION

However, in the methods for deleting the surface dependency described above, there are the following problems :

That is, in the method forming the silicon oxide film as the base layer on the surface of the substrate by the CVD method described in the item ①,
since the silicon oxide film by the plasma enhanced CVD method is poorly good in step coverage, it is not suitable for embedding the recess narrow in width and deeper in depth.

Moreover, in the method of the item ② exposing the surface of the substrate to plasma gases, since a plasma apparatus is required, the apparatus becomes extensive. Moreover, in such method, there are problems that an increase in cost is led and it is a question whether reform can be performed up to the bottom of the recess narrow in width and deeper in depth or not by the plasma.

Furthermore, in the method of the item ③, a thickness of the Low O₃/TEOS SiO₂ film is required at least 50 nm or more. It is not suitable for embedding to the recess narrow in width and deeper in depth.

Moreover, with regard to the item ④and the item ⑤ also, there are the same problems as the item ②and the item ③.

### SUMMARY OF THE INVENTION

It is the object of this invention to provide a method of film formation and a method for manufacturing a semiconductor device capable of securely deleting the surface dependency of the substrate to form an insulating film being excellent in film quality.

The object of this invention is to provide a method of film formation and a method for manufacturing a semiconductor device capable of embedding the insulating film without clearance in a recess of the substrate having the recess narrow in width and deeper in depth.

As described above, in this invention, a phosphorus-containing insulating film such as a phosphosilicate glass film is formed as a base layer on the surface of the substrate. Furthermore, on the phosphorus-containing insulating film, a silicon-containing insulating film is formed by a chemical vapor film formation using the mixed gas containing the ozone-containing gas and a silicon-containing gas.

According to experiments by the inventor of the application concerned, in the case of depositing the silicon-containing insulating film by a chemical vapor deposition method using the mixed gas containing the ozone containing gas and a silicon-containing gas on the substrate, the surface dependency of the substrate can be deleted by sheathing the surface of the substrate with the phosphorus-containing insulating film such as a phosphosilicate glass film (a PSG film) or a borophosphosilicate glass film (BPSG film).

Incidentally, it has been stated that, when the High O₃/TEOS SiO₂ film is formed by the chemical vapor deposition method using the ozone-containing gas and a silicon-containing gas containing high concentration ozone (defined as the concentration of ozone in oxygen is 1 % or more), the surface dependency to the deposition film on the substrate appears remarkably. According to the invention, since the surface dependency can be deleted by sheathing the surface of the substrate with the phosphorus containing insulating film, the sufficient fluid ability can be obtained, even when the High O₃/TEOS SiO₂ film being ready to be influenced by the surface dependency is deposited.

Moreover, the surface dependency can be deleted sufficiently by phosphorus-containing insulating film with a thin film thickness of approximate 10 nm in film thickness. Therefore, even the inside of the recess narrow of, at least, approximate 20 nm or more in width can be sheathed. Moreover, the upper limit of the film thickness of phosphorus-containing insulating film is influenced by the width of the recess. At this point of time, the film thickness of the phosphorus-containing insulating film is defined preferably such that the film thickness of the phosphorus-containing insulating film becomes thin sufficiently as compared with the silicon-containing insulating film in the entire film thickness of an interlayer dielectric film constituted by the phosphorus containing insulating film as the base layer and the silicon containing insulating film which lies thereon. Usually, it can be acceptable sufficiently when being formed within approximate 100 nm.

Therefore, when there is the recess narrow in width and deeper in depth on the surface of the substrate, recess can be embedded with the silicon oxide film without clearance, without generating voids and seams on the silicon oxide film formed in recess.

In this case, the ozone-containing gas, the silicon-containing gas and the phosphorus-containing gas are discharged by a first gas discharge means to form the phosphorus-containing insulating film and then the ozone-containing gas and the silicon-containing gas are discharged by a second gas discharge means continuously after ceasing the discharge by the first discharge means to form the silicon oxide film. Incidentally, it has been found by the experiments that in order to delete the surface dependency of the surface of the phosphorus-containing insulating film, when subsequently forming the silicon-containing insulating film on the phosphorus-containing insulating film, it is required to perform such that no phosphorus-containing gas is contained in the reaction gas. That is, when the silicon-containing insulating film is formed using a gas discharge means which differs from the gas discharge means where forming the phosphorus-containing insulating film, the surface dependency at the surface of the phosphorus-containing insulating film can be deleted. A deposition chamber for the phosphorus-containing insulating film may be swapped with a deposition chamber for the silicon-containing insulating film or the alternate gas discharge means may be switched respectively upon forming also.

Moreover, the following fact has been verified by the experiments. After the process forming the phosphorus-containing insulating film and before the process forming the silicon-containing insulating film on the phosphorus-containing insulating film, the surface of the phosphorus-containing insulating film is exposed to the atmosphere, or the surface of the phosphorus-containing insulating film is exposed to water vapor while heating the surface of the phosphorus-containing insulating film. Therefore, the surface of the phosphorus-containing insulating film is converted to hydrophobicity, and when the surface of the phosphorus-containing insulating film is converted to hydrophobicity, the surface dependency in the mentioned-above depositing film can be suppressed. Especially, when the High O₃/TEOS SiO₂ film being ready to be influenced by the surface dependency is deposited, such treatment is performed preferably.

Furthermore, the ozone-containing gas used in the film formation of the silicon-containing insulating film is the gas containing ozone of the concentration of less than 10 % in oxygen.

As described above, to use the phosphorus-containing insulating film as the base layer is effective, in particular, when depositing the High O₃/TEOS SiO₂ film being ready to be influenced by the surface dependency using the high ozone-containing gas such that the concentration of ozone in oxygen is as high as 1 % or more.

As a matter of course, this is effective also when depositing the silicon oxide film (the Low O₃/TEOS SiO₂ film) being not ready to be influenced by the surface dependency using the low ozone containing gas such that the concentration of ozone in oxygen is as low as less than 1 %.

The reason why is that according to this deposition, penetration of moisture and migration of alkali ions from the Low O₃/TEOS SiO₂ film to the substrate can be prevented.

In the case of depositing the silicon-containing insulating film by CVD method using the mixed gas of the O₃/TEOS, the flowability of the depositing film can be increased by regulating the deposition temperature within the range of 350°C to 550°C. In the described-above deposition temperature, in order to obtain the particularly sufficient flowability of the depositing film, it is preferable that the deposition temperature is regulated within the range of 375°C to 425°C.

### BRIEF DESCRIPTION OF THE DRAWINGS

Fig.1A to Fig.1C are flowcharts of a method of film formation and a method for manufacturing a semiconductor device according to embodiments of the invention.
Fig.2A and Fig.2B are photography showing cross-section shapes of a silicon-containing insulating film formed on a substrate with a step and a groove by the method of film formation and the method for manufacturing the semiconductor device according to embodiments of the invention.
Fig.3A is a sectional view showing a substrate with a step used in the method of film formation and the method for manufacturing the semiconductor device according to embodiments of the invention.
Fig.3B is a sectional view showing a substrate with a trench groove used in the method of film formation and the method for manufacturing the semiconductor device according to embodiments of the invention.
Fig.4 is a view showing the correlation between the surface dependency of a deposition rate and an angle of contact of the O₃/TEOS NSG film being formed by the method of film formation according to embodiments of the invention.
Fig.5 is a graph obtained by investigating, by showing types of the base layers as a parameter, the correlation between the ratio of the deposition rates and an ozone concentration of the O₃/TEOS NSG film being formed by the method of film formation according to embodiments of the invention.
Fig.6 is a side view showing a constitution of a deposition chamber applied to the method of film formation according to embodiments of the invention.
Fig.7 is a sectional view showing cross-section shape of a silicon-containing insulating film formed on a substrate with the step and the groove by the method of film formation according to a comparison example.

### DESCRIPTION OF THE PREFRRED EMBODIMENTS

Hereafter, the embodiments of the invention are described referring to the drawings.

### (1)Basic data of this invention

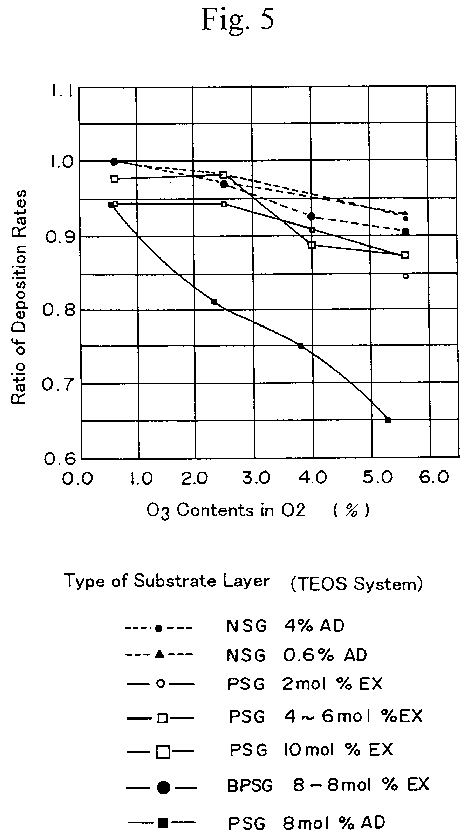

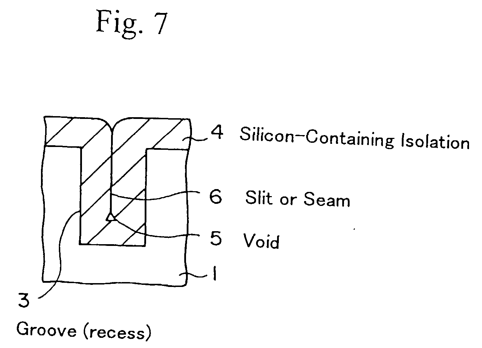

This invention is based on knowledge in the depositing reaction of the O₃/TEOS SiO₂ film in the case using a chemical vapor deposition method (a CVD method) as described below items (i) to (iv).
(i)The flowability during depositing the O₃/TEOS SiO₂ film appears at the deposition temperature within the range of 375°C to 425°C.
On the other hand, when the deposition temperature exceeds 450°C, isotropic growth is shown. At temperature exceeding 500°C, the deposition of the silicon-containing insulating film by the CVD method used the mixed gas of O₃+TEOS (hereinafter represented as an O₃/TEOS) becomes the perfectly isotropic deposition.
In this case, the silicon-containing insulating film 4 is also capable of being formed in a narrow and deep recess 3 as shown in FIG.7. However, a void 5 or slit 6 may occur if a thickness of the silicon-containing insulating film 4 is thicker.

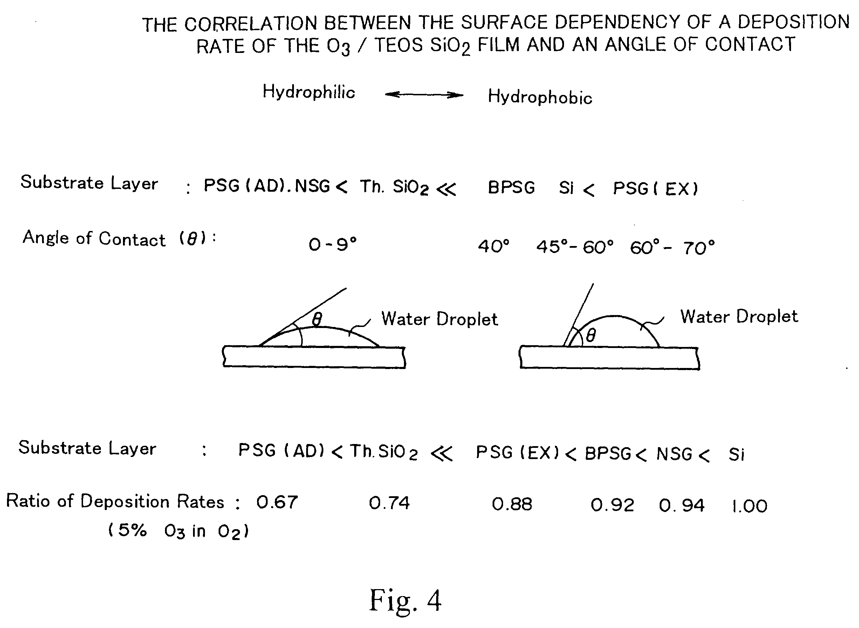

(ii)Fig.4 is a view showing the relationship among a property of the surface whether the base layer surface is hydrophilic or hydrophobic, an angle of contact (θ)of water deposited on a base layer surface and the ratio of the deposition rates of various films being formed on the base layer.
As shown in Fig. 4, where an angle of contact (θ) refers to the angle which the tangent to the drop of water at the contact surface with the base layer surface forms with the base layer surface, when water deposited on a base layer surface is flocculated to make a drop of water by surface tension. A ratio of the deposition rates refers to the ratio of the deposition rate where the same film is film-deposited on various base layers with respect to the deposition rate where various films are formed on silicon surface directly. It is shown that as the ratio of the film deposition rates approaches 1, the surface dependency is more suppressed.
Moreover, the term "Th.SiO₂" in Fig.4 refers to the silicon oxide film formed by thermal oxidation. The term "AD" refers to "as deposited", that is, the meaning of "immediately after deposition". The term "EX" refers to "after exposure", that is, the meaning of "after exposing to the atmosphere".
In the comparison data of the ratio of the deposition rates, the high ozone-containing gas that the concentration of ozone in oxygen is 5 % is used as an oxidizing gas used in the film formation of a phosphosilicate glass (PSG)(AD), an impurity-free silicon oxide film (NSG), a borophosphosilicate glass film (BPSG) and PSG (EX) in various films.
As shown in Fig.4, the surface dependency of the O₃/TEOS SiO₂ film to the base layer is influenced depending upon the angle of contact (θ) of water deposited on the base layer surface, that is, whether being hydrophilic or hydrophobic.
That is, when the surface of the base layer is hydrophilic, the surface dependency of the depositing film is high, and when the surface of the base layer is hydrophobic, the surface dependency of the depositing film is low. Moreover, in Fig4. the reason why even though the NSG is hydrophilic, the surface dependency of the depositing film to the base layer is low is unknown with the current state of the art.
(iii)Fig.5 is a graph showing the relationship between the ozone concentration in the ozone-containing gas used in film formation of the NSG film deposited on the base layer and the ratio of the deposition rates of the NSG film. The various films as the base layers are shown as a parameter.
The ratio of the deposition rates expressed in a linear scale is shown on the vertical axis the horizontal axis. The concentration of ozone (%) in oxygen expressed in a linear scale is shown on the horizontal axis.
Moreover, in the indication of the various films as the base layers, the indication of "NSG 4% AD" shows that it is the NSG film formed using the ozone-containing gas that the concentration of ozone is less than 4 %. In addition, it shows that immediately after deposition, deposition is performed thereon.
The indication of "PSG 2 mol % EX" shows that it is the PSG film containing phosphorus of 2 mol % and after exposing to the atmosphere, deposition is performed thereon.
The indication of "PSG 4 to 6 mol % EX" refers to the PSG film containing phosphorus of 4 to 6 mol %.
The indication of "BPSG 8 to 8 mol % AD" shows that it is the BPSG film containing boron of 8 mol % and phosphorus of 8 mol % and immediately after deposition, deposition is performed thereon.
Other indications conform to the described-above indications. Moreover, the concentration of ozone in the ozone-containing gas used in deposition ofthe PSG film and the BPSG film is both defined as 4 %.
As shown in Fig.5, there is the significant correlation between the concentration of ozone in the ozone-containing gas used in deposition of the silicon-containing insulating film and the surface dependency.
Moreover, in the case that the base layer is the PSG, immediately after deposition of the base layer (AD), the surface dependency in the base layer is high. However, it is understood that when the base layer is exposed to the atmosphere (EX), the surface of the base layer is converted from hydrophilic to hydrophobic, whereby the surface dependency of the depositing film become low.
Next, the degree of the surface dependency according to the type of the base layer is shown in Table 1.

**Table 1**

| Surface dependency | Type depositing film | Type of base layer |
|---|---|---|
| High (DR < 0.7) | High O₃ NSG film | Th.SiO₂ HD PSG (AD) SOG |
| Low (0.7 < RD < 1.0) | High O₃ NSG film BSG film | BSG, PSG (EX) BPSG, P-SiO SiN |
| No dependence | High O₃ NSG film | P-SiO, Al, refractory metal polysilicon, silicon |
| | PSG film, BPSG film Low O₃ NSG film | Every type of clean substrate |
| Note) 1. A High O₃ NSG film refers to a High O₃/TEOS SiO₂ film. 2. A Low O₃ NSG film refers to a Low O₃/TEOS SiO₂ film. 3. A HD PSG (AD) refers to the PSG film which contains a high concentration phosphorus and is the film immediately after being formed. 4. PSG (EX) refers to the posterior PSG film which was exposed to the atmosphere after deposition. 5. A P-SiO refers to the silicon oxide film deposited by plasma of gas containing the TEOS. | | |

Table 1 is the table comparing the degrees of the surface dependencies where the Low O₃ NSG film (referred to the Low O₃/TEOS SiO₂ film) base layer, the High O₃ NSG film (refer to the High O₃/TEOS SiO₂ film), the BSG film, the PSG film or the BPSG film are formed on the various films as the base layer.
According to Table 1, the High O₃ NSG film is influenced strongly by the surface dependency of the base layer when being deposited on a Th. SiO₂, HDPSG (AD) (refer to a high concentration phosphorus-containing PSG film (AD)) or a SOG (Spin-On-Glass) as the base layer. That is, the ratio of the deposition rates (DR) becomes less than 0.7.
On the other hand, the influence by the surface dependency of the base layer is an intermediate degree, when the High O₃ NSG film is deposited on BPSG, BSG, PSG (EX), or P-SiO film as the base layer. That is, the ratio of the deposition rates (DR) becomes 0.7 or more and less than 1.
Moreover, in the case of depositing a P-SiO, it is not influenced perfectly by the surface dependency under that P-SiO film. Furthermore, even when on any type of surface, the PSG film and the BPSG film beginning with the Low O₃ NSG film are deposited, these films are not influenced perfectly by the surface dependency under the PSG film and the BPSG film.
Moreover, a P-SiO film is the silicon oxide film deposited using plasma of a gas containing the TEOS. Moreover, a "SiN film" represents the silicon nitride film.
Other films can be interpreted in conformance with the described-above description.
(iv)When the O₃/TEOS SiO₂ film is deposited on the base layer, a so-called barrier layer or a shield layer is required between the base layer and the O₃/TEOS SiO₂ film. The barrier layer or the shield layer is required for insulating the O₃/TEOS SiO₂ film and the base layer surface, for preventing moisture from transmitting and for deleting the surface dependency of the depositing film in the base layer or the like. Moreover, the base layer surface being exposed to some types of materials is required to be uniformed.

This invention is devised based on the knowledge described above, and hereinafter, embodiments of the invention are described.

### (2)Embodiments of the Invention

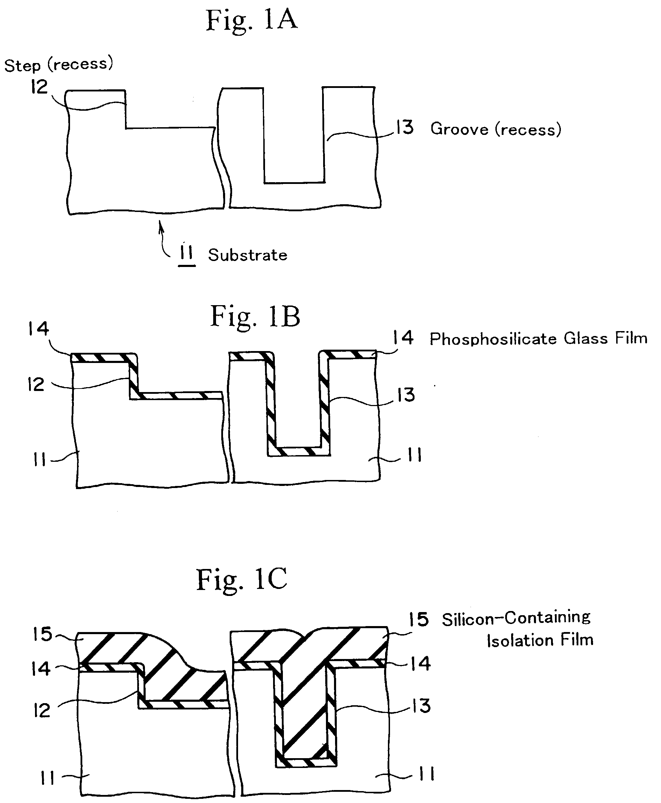

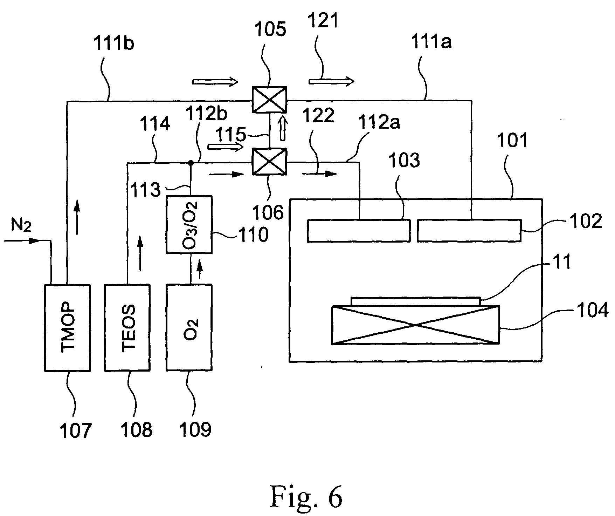

Fig.1A to Fig.1C are sectional views illustrating the embodiments of the invention. FIG.6 is a side view showing a constitution of the deposition chamber.

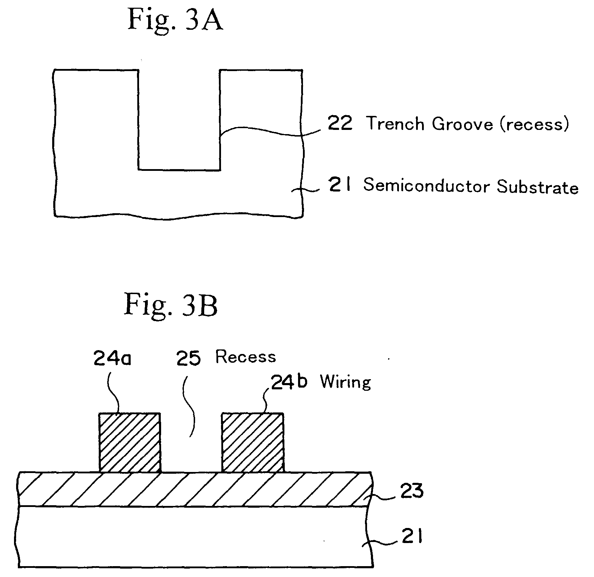

First, a substrate 11 shown in Fig. 1A is placed on a placing table 104 in a deposition chamber 101. On the surface of the substrate 11, asperties are caused by a step (a recess) 12 and a groove (a recess) 13. For example, as shown in Fig. 3A and 3B, such asperties are the asperties being caused by a trench groove 22 formed on a surface of a semiconductor substrate 21 and wiring 24a and 24b formed on a base insulating layer 23.

Subsequently, the substrate 11 is heated to be kept within the temperature of 350°C to 550°C. The temperature is kept preferably within 375°C to 425°C. In this embodiment, for example, it is defined as 400°C.

Next, as shown in Fig.1B, a phosphosilicate glass film (a phosphorus-containing insulating film) 14 thin in thickness is deposited on the surface of the substrate 11 as the base layer by the CVD method. For this purpose, a gas conduit 112a reaching a gas discharge means 103 is closed and gas conduits 112b-115-111a, and 111b-111a are communicated by valve 105, 106. With this, a reaction gas 121 consisting of the ozone-containing gas that the concentration of ozone in oxygen is 5 % and a nitrogen gas containing the TEOS (a silicon-containing gas) and TMOP (Trimetylphosphate (PO(OCH₃)₃) : a phosphorus-containing gas) are introduced to a first gas discharge means 102 on the substrate 11. The ozone-containing gas is supplied through an O₂ source 104 and ozonizer110, a nitrogen gas containing the TEOS is supplied through TEOS source 108, and TMOP is supplied through TMOP source 107.

The reaction gas reacts by the temperature of the substrate 11 being increased by heating to deposit a phosphor glass film 14 on the substrate 11.

At this point of time, the flow rate of the TMOP is adjusted in advance such that a phosphorus content in the phosphosilicate glass film 14 becomes less than 10 %.

Moreover, the film thickness of the phosphosilicate glass film 14 is determined such that the film thickness becomes the sufficient thickness required to delete the surface dependency and in consideration of a width and a depth of the step (the recess) 12 and the groove (the recess) 13. That is, the sufficient thickness required to delete the surface dependency has been found to be approximate 10 nm or more by the experiments

Moreover, the film thickness of the phosphosilicate glass film 14 is influenced by the width of (the recess), whereby it is preferable to be formed as thin as possible such that the groove (the recess) 13 is not filled with only the phosphosilicate glass film 14. In general, in the entire film thickness of the interlayer dielectric film constituted by the phosphosilicate glass film 14 as the base layer and a silicon oxide film 15 laying thereon, the film thickness of the phosphosilicate glass film 14 is preferably established so that the film thickness of the phosphosilicate glass film 14 becomes sufficiently thin as compared with the film thickness of the silicon oxide film 15. Usually, when the film thickness of the phosphosilicate glass film 14 is approximate 100 nm, it can be recognized to be sufficiently thin. In this embodiment, for example, a deposition time is established such that the film thickness of the phosphosilicate glass film 14 becomes 10 nm or more and less than 100 nm.

After a lapse of the deposition time established by the above description, the phosphosilicate glass film 14 within the range of 10 to 100 nm in thickness is formed on the substrate 11. Since the deposition temperature of the phosphosilicate glass film 14 is within the range of 375°C to 425°C, the phosphosilicate glass film 14 is smooth and grows in an approximately isotropic condition regardless the type of material exposed to the substrate 11. Moreover, the surface dependency of the depositing film is deleted by the phosphosilicate glass film 14.

Moreover, it is effective to perform the treatment exposing to water vapor under the condition of heating at the same temperature as the deposition temperature in the deposition chamber, before forming the silicon oxide film (the silicon-containing insulating film) on the phosphosilicate glass film 14. Therefore, the surface on the phosphosilicate glass film 14 is converted from hydrophilic to hydrophobic.

Subsequently, the TMOP is stopped and a gas supplying line is switched to a different gas supplying line 112b-111a from the gas supplying lines 112b-115-111a and 111b-111a through which the reaction gas 121 containing the TMOP flew. Therefore, the ozone containing gas containing the same concentration ozone where the phosphosilicate glass film 14 is deposited and the TEOS (a silicon-containing gas) continuously flow into the same deposition chamber 101 through the second gas discharge means 103 on the substrate 11. Moreover, the temperature of the substrate also is kept as it is. That is, the temperature of the substrate is kept within the temperature of 350°C to 550°C, preferably within 375°C to 425°C in common with the deposition temperature of the phosphosilicate glass film.

As shown in Fig. 1C, while keeping this condition, the silicon-containing insulating film (the High O₃/TEOS SiO₂ film : the silicon-containing insulating film) 15 is formed on the phosphosilicate glass film 14. At this point of time, since the surface dependency of the depositing film in the base layer has been deleted, the High O₃/TEOS SiO₂ film 15 being deposited exhibits the significant flowability and flows into the recess 13 narrow in width.

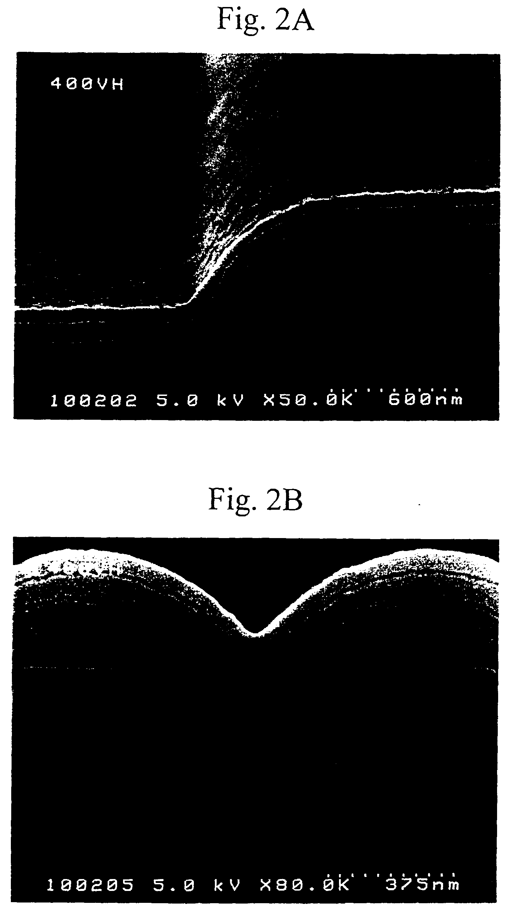

Fig.2A and Fig.2B are photography showing cross-section of the High O₃/TEOS SiO₂ film 15 formed in the recess 12 wide in width and 13 narrow in width on the substrate 11. The striped patterns observed in the High O₃/TEOS SiO₂ film 15 in the photography are caused by forming a different layer at each deposition of the High O₃/TEOS SiO₂ film 15 with the predetermined film thickness in order to facilitate to observe how the depositing film deposits.

As shown in Fig.2A, at the recess 12 wide in width, formation of a flowing shape is recognized and moreover, as shown in Fig. 2B, at the recess 13 narrow in width, generation of the voids and the seams in the High O₃/TEOS SiO₂ film 15 of the recess 13 can be suppressed to embed the High O₃/TEOS SiO₂ film 15 into the recess 13 without clearance.

As described above, according to the embodiments of the invention since the surface dependency of the depositing film can be deleted by sheathing the surface of the substrate 11 with the phosphosilicate glass film 14, the sufficient fluid ability can be obtained, even when the High O₃/TEOS SiO₂ film 15 being ready to be influenced by the surface dependency is deposited.

Since the surface dependency of the depositing film can be deleted sufficiently by the phosphosilicate glass film 14 with the thin film thickness, even the inside of the recess narrow in width can be sheathed sufficiently.

Therefore, when there is the recess 13 narrow in width on the surface of the substrate 11, the High O₃/TEOS SiO₂ film 15 can be embedded into the recess 13 without clearance, without generating the voids and the seams on the High O₃/TEOS SiO₂ film 15 in the recess 13.

Furthermore, since the deposition temperature at forming the High O₃/TEOS SiO₂ film 15 is regulated within the range of 350°C to 550°C, preferably within the range of 375°C to 425°C, on the occasion of depositing the High O₃/TEOS SiO₂ film 15 by the CVD method using the mixed gas of the O₃/TEOS, the flowability of the depositing film can be increased.

Moreover, in the embodiments of the invention described above, although the PSG film is used as the base layer 14, the BPSG film may be used as a substitute of the PSG film.

As the ozone-containing gas used in deposition of the silicon-containing insulating film 15 on the base layer 14, the High O₃/TEOS SiO₂ film is formed using the gas containing the high concentration ozone such that the concentration of ozone in oxygen is as high as 1% or more and less than 10%. However, it can be applied also in the case of depositing the silicon oxide film (the Low O₃/TEOS SiO₂ film) being not ready to be influenced by the surface dependency using the ozone containing gas containing the low concentration ozone such that the concentration of ozone in oxygen is as low as less than 1 %. In this case, by using the phosphorus-containing insulating film 14 such as the phosphosilicate glass film, in particular, penetration of moisture and migration of alkali ions from the Low O₃/TEOS SiO₂ film to the substrate can be prevented except deleting of the surface dependency of the depositing film.

Furthermore, in the above description, after depositing the phosphosilicate glass film 14 and before forming the silicon oxide film 15, the surface of the phosphosilicate glass film 14 is converted to hydrophobicity by exposing to water vapor. However, the gas discharge means used at forming the phosphosilicate glass film 14 may be swapped with an alternate gas discharge means which is perfectly free from the deposition of phosphorus. Whether this or that, the substrate 11 may be moved out of the deposition chamber to expose to the atmosphere. Therefore, the surface dependency in the surface of the phosphosilicate glass film 14 can be deleted.

Moreover, in the above description, although the phosphosilicate glass film (the phosphor-containing insulating film) 14 is formed within the range of 10 to 100 nm in thickness, this is never limited thereto. Theoretically, it is essential only that the film thickness of the phosphorus-containing insulating film is less than one half of the width of the recess. Accordingly, the upper limit of the film thickness of the phosphorus-containing insulating film would be influenced by the width of the recess.

As described above, in the invention, the surface of the substrate is sheathed with the phosphorus-containing insulating film such as the phosphosilicate glass film. Therefore, the surface dependency of the depositing film can be deleted to the substrate to obtain the sufficient fluidity at depositing.

Moreover, the gas containing ozone of less than 10 % in oxygen is used as the ozone-containing gas used in deposition of the silicon-containing insulating film.

That is, it is applied to the High O₃/TEOS SiO₂ film which is deposited using the high ozone-containing gas such that the concentration of ozone in oxygen is 1 % or more and which is ready to be influenced by the surface dependency, or the silicon oxide film (the Low O₃/TEOS SiO₂ film) which is deposited using the low ozone containing gas that the concentration of ozone in oxygen is less than 1 % and which is not ready to be influenced by the surface dependency.

In the case of applying to the deposition of the High O₃/TEOS SiO₂ film, it is effective for deleting the surface dependency, and in the case of applying to the deposition of the Low O₃/TEOS SiO₂ film, it is effective for preventing penetration of moisture and migration of alkali ions from the Low O₃/TEOS SiO₂ film to the substrate rather than for deleting the surface dependency.

Moreover, since the surface dependency of the depositing film can be deleted sufficiently by using the phosphorus-containing insulating film such as the phosphosilicate glass film, even the inside of the recess narrow in width can be sheathed sufficiently.

Therefore, when there is the recess narrow in width on the surface of the substrate, the recess 13 can be embedded with the silicon oxide film without clearance, without generating the voids and the seams on the silicon oxide film formed in the recess.

Furthermore, since the deposition temperature at forming the silicon-containing insulating film is regulated within the range of 350°C to 550°C, preferably within the range of 375°C to 425°C, on the occasion of depositing the silicon-containing insulating film by the CVD method using the mixed gas of the O₃/TEOS, the flowability of the depositing film can be increased.

## Claims

1. A method of film formation comprising the steps of :
forming a phosphorus-containing insulating film(14) on a surface of a substrate(11) as a base layer ; and
forming a silicon-containing insulating film(15) on said phosphorus-containing insulating film(14) by a chemical vapor deposition using a mixed gas containing a ozone-containing gas and a silicon-containing gas.

2. A method of film formation comprising the steps of :
discharging a ozone-containing gas, a silicon-containing gas and a phosphorus-containing gas by a first gas discharge means(102) to form a phosphorus-containing insulating film(14) on a surface of a substrate(11) as a base layer by a chemical vapor deposition; and
discharging the ozone-containing gas and the silicon-containing gas by a second gas discharge means(103) which differs from said first gas discharge means(102) continuously after ceasing the discharge by the first gas discharge means(102) to form a silicon-containing insulating film(15) on said phosphorous-containing insulating film(14) by the chemical vapor deposition.

3. The method of film formation according to claim 1 or 2, wherein after a step of forming said phosphorus-containing insulating film and before a step of forming the silicon-containing insulating film on said phosphorus-containing insulating film, a surface of said phosphorus-containing insulating film is exposed to the atmosphere, or the surface of said phosphorus-containing insulating film is exposed to water vapor while heating the surface of said phosphorus-containing insulating film.

4. The method of film formation according to claim 1 or 2, wherein a film thickness of said phosphorus-containing insulating film deposited is within the range of 10 nm to 100 nm.

5. The method of film formation according to any one of claim 1 to 4, wherein said ozone-containing gas is a gas containing ozone of a concentration of not more than 10 % in oxygen.

6. The method of film formation according to claim 1 or 2, wherein said silicon-containing gas is a gas containing tetraethylorthosilicate (TEOS).

7. The method of film formation according to claim 1 or 2, wherein a deposition temperature during forming said silicon-containing insulating film is within the range of 350°C to 550°C.

8. The method of film formation according to claim 7, wherein the deposition temperature during forming said silicon-containing insulating film is within the range of 375°C to 425°C.

9. The method of film formation according to claim 1 or 2, wherein said phosphorus-containing insulating film is any one of a phosphosilicate glass film (a PSG film) and a borophosphosilicate glass film.

10. The method of film formation according to claim 9, wherein a phosphorus concentration in said phosphosilicate glass film is not more than 10 mol %.

11. A method for manufacturing a semiconductor device comprising the steps of :
forming the phosphorus-containing insulating film (14) for sheathing a recess (12), (13) as the base layer on the surface of the substrate (11) having said recess (12), (13); and
subsequently forming a silicon-containing insulating film (15) on said phosphorus-containing insulating film (14) by a chemical vapor deposition using a mixed gas containing a ozone-containing gas and a silicon-containing gas, so that said recess (12), (13) is embedded with the silicon oxide film (15).

12. A method of film formation comprising the steps of :
discharging a ozone-containing gas, a silicon-containing gas and a phosphorus-containing gas by a first gas discharge means (102) to form a phosphorus-containing insulating film (14) for sheathing a recess (12), (13) on a surface of a substrate (11) having said recess (12), (13) as a base layer by a chemical vapor deposition; and
discharging the ozone-containing gas and the silicon-containing gas by a second gas discharge means (103) which differs from said first gas discharge means (102) continuously after ceasing the discharge by the first gas discharge means (102) to form a silicon-containing insulating film (15) on said phosphorous-containing insulating film (14) by the chemical vapor deposition, so that said recess (12), (13) is embedded with the silicon oxide film (15).
